# EUROPEAN PATENT SPECIFICATION

(11) **EP 1 900 844 B1**
(45) Date of publication and mention of the grant of the patent: **18.05.2011**
(21) Application number: 07013798.9
(22) Date of filing: 13.07.2007
(51) Int. Cl.: C23C 14/06, C23C 14/02

(54) **Article with high-hardness carbon coating**
Gegenstand mit Kohlenstoffbeschichtung von großer Härte
Article doté d'un revêtement en carbone à dureté élevée

(30) Priority: 12.09.2006 JP 2006246241
(43) Date of publication of application: 19.03.2008
(73) Proprietor: Hitachi, Ltd., Chiyoda-ku Tokyo 100-8280 (JP)
(72) Inventor: Nakashima, Shoichi, Tokyo 1008280 (JP); Okamoto, Shinya, Tokyo 1008280 (JP); Baba, Noboru, Tokyo 1008280 (JP); Yamaguchi, Shizuka, Tokyo 1008280 (JP)
(74) Representative: Kirschner, Klaus Dieter

(56) References cited:
- EP-A- 0 718 417
- US-A- 5 249 554
- US-A1- 2002 136 895
- US-B1- 6 387 443
- NÖTHE M., BUURON A., KOCH F., PENKALLA H. J., REHBACH W. P., BOLT H.: "investigation of the properties of a-C:H coatings with graded metal interlayers" FRESENIUS J. ANAL. CHEM., vol. 365, 1999, pages 249-254, XP002551560

## Description

The present invention relates to an article having a high-hardness carbon coating.

In recent years, in order to lower friction loss of sliding members, forming of ceramics hard coatings such carbides as TiC or such metal nitrides as TiN on a substrate is widely employed.

Ceramic hard coatings are superior in abrasion resistance, but they have a friction coefficient of about 0.5 under no lubricant condition in an atmosphere. Thus, a lower friction coefficient has been required.

On the other hand, a self-lubricating sulfide compound coating such as molybdenum disulfide coating has been used, but it has a problem in life that the substrate is exposed by abrasion of the coating.

Recently, a high-hardness carbon coating has been in the spotlight. The high-hardness carbon coating is called DLC (Diamond Like Carbon) or amorphous carbon. The high-hardness carbon coating has a low friction resistance of graphite and high-hardness of diamond as well. It has such a low friction coefficient as about 0.1 in the atmosphere so that it has an excellent abrasion resistance.

On the other hand, since the high-hardness carbon coating is hard and brittle, it has problems in fitness or load resistance because it generates cracks or peel-off when it is applied on metallic substrates. Against these problems, an intermediate layer of silicon layer or chromium layer is generally formed between the high-hardness carbon coating and the metallic substrate, since Si and Cr are excellent for adhesion to both the metallic substrate and the high-hardness carbon coating.
An attempt has been made to obtain a higher adhesion, which is disclosed in Japanese patent laid-open publication 2004-169137 and Japanese patent laid-open publication 10-203896 wherein a multilayered intermediate layer is disclosed.

"Nöthe M., Buuron A., Koch F., Penkalla H. J., Rehmach W. P., Bolt H.: "Investigation of the properties of a-C:H coatings with graded metal interlayers", Fresenius J. Anal. Chem., vol. 365, 1999, pages 249-254, XP002551560" discloses a combined physical vapor deposition/chemical vapor deposition process which was used to deposit Al interlayers with mixed interface to a-C:H coatings on Si and steal substrates. The Al interlayers have a typical thickness of 100 nm to 1 µm with a-C:H layers of 0,5 to 3 µm thickness. Transmission electron microscopy element mappings and secondary ion mass spectroscopy analysis showed that Al and C-distributions overlap, indicating the formation of a compositionally graded interlayer. Scanning electron microscopy fracture cross-sections indicate that delamination of a-C:H coatings with metal interlayer occurs preferably near the substrate metal interface.

Since light metal alloys such as aluminum alloys (Al alloy), magnesium alloys (Mg alloy), titanium alloys (Ti alloy) are softer than steel materials, the high-hardness carbon coating (hereinafter referred to as carbon coating) may peel off by itself by stress concentration in an interface between the coating and the substrate when a thickness of the coating is large. Even if the coating is formed, the coating may be easily peeled off from the substrate by friction or scratching.

Though a method of forming an intermediate layer of Si or Cr as a stress relaxation layer has been known, which has an effect of preventing peeling-off in case of coatings of particular hardness or Young's modulus, durability of the coating comparable to anodized coating was not obtained.

Further, in case of substrates of light weight metals, a heat treatment temperature for increasing strength of the substrates is low; the substrates tend to be softened, due to an temperature rise during formation of the coating.

Accordingly, the present invention aims at providing an article, especially sliding article with excellent adhesion and abrasion resistance, and with low friction as well.

The above object is achieved by the article according to the independent claims, whereas preferred embodiments of such article are characterized in the sub claims.

Embodiments of the invention are now described with reference to the drawings.
Fig. 1 is a secondary electron image photograph of a cross section of a carbon coating of the present invention by a scanning electron microscope (SEM).
Fig. 2 is a perspective view of a test specimen.
Fig. 3 is a graph showing a relationship among Al concentration, hardness and Young's modulus of films.
Fig. 4 is a graph showing a relationship among an Al concentration (at%), electric powers for targets and time for forming films of the films of the present invention.
Fig. 5 is a graph showing a relationship among an Al concentration (at%), electric powers for targets and time for forming films of the films of comparative member 2.
Fig. 6 is a graph showing a relationship among an Al concentration (at%), electric powers for targets and time for forming films of the films of comparative member 4.
Fig. 7 is a graph showing a relationship among an Al concentration (at%), electric powers for targets and time for forming films of the films of comparative member 5.
Fig. 8 is a graph showing an Al concentration of a carbon coating of the present invention.
Fig. 9 is a perspective view of a piston to which the present invention is applied.
Fig. 10 is a diagrammatic perspective view of a reciprocal sliding mechanism of the present invention.

In one embodiment of the present invention, an article comprises a substrate of aluminum base alloy, magnesium base alloy, or titanium base alloy, an intermediate layer having a thickness of 1 to 2.5 micrometers and containing aluminum and carbon on the substrate, and a high-hardness carbon coating (diamond like carbon layer) having a thickness of 1 to 2.5 micrometers on the intermediate layer.

A concentration of aluminum in the intermediate layer decreases along the direction from the substrate towards the high-hardness carbon coating, but a concentration of carbon in the intermediate layer increases along the direction from the substrate towards the high-hardness carbon coating. At the same time, Al4C3 whose atomic ratio of aluminum to carbon is 4 to 3 is formed in a halved intermediate layer at the substrate side, and the high-hardness carbon coating contains 0.5 to 4.5 at%.

In another embodiment of the present invention, an article comprises a substrate, an intermediate layer containing aluminum and carbon on the substrate, and a high-hardness carbon coating on the intermediate layer, wherein a concentration of aluminum in the intermediate layer decreases along the direction from the substrate towards the high-hardness carbon coating, a decreasing rate in the intermediate layer at the high-hardness carbon coating side being smaller than that in the substrate side.

The high-hardness carbon coating contains aluminum in 0.5 to 4.5 atomic %. A concentration of carbon in the intermediate layer increases along the direction from the substrate towards the high-hardness carbon coating in the intermediate layer at the high-hardness carbon coating side.

The substrate is preferably made of an aluminum base alloy containing copper of 1 to 2 at%, other aluminum base alloys, magnesium base alloys, titanium base alloys, aluminum, magnesium; or titanium. The high-hardness carbon coating should preferably be diamond like carbon.

A thickness of the high-hardness carbon coating should preferably be 1 to 2.5 micrometers. A thickness of the intermediate layer is 1 to 2.5 micrometers. In another embodiment of the article of the present invention, the intermediate layer on the substrate contains aluminum and carbon, and the high-hardness carbon coating on the intermediate layer, wherein Al4C3 formed in the intermediate layer is present in a halved area of the intermediate layer at the substrate side.

It is preferable to form an aluminum base alloy or aluminum layer in the interface between the substrate and the intermediate layer. The intermediate layer is preferably formed by a physical vapor deposition method. Properties of the high-hardness carbon coating (herein referred to as a coating) can be changed by adding hydrogen or metallic elements thereto. Aluminum was added to the coating, and a concentration of aluminum, hardness, Young's modulus, friction coefficient and abrasion amount were investigated in detail. As a result, properties of the coating change as a concentration of aluminum.

Based upon the results of the properties of the coating, an optimum intermediate layer was investigated. It has been revealed that when the concentration of aluminum is changed properly from the surface of the substrate towards the surface of the coating so as to relax the stress concentration, adhesion of the coating was improved.

The intermediate layer formed at the substrate side, for example, should have a composition that gives the intermediate layer substantially the same strength as that of the substrate, and should have a surface with a low friction and an interior with excellent abrasion resistance.

The intermediate layer formed between the coating and the substrate should be made of metallic material so as to harmonize the stress relaxation and deformability and should have a composition that gives the layer a strength close to that of the substrate.

Besides aluminum including unavoidable impurities, a composition of the intermediate layer made of a aging-hardened type light metal alloy such as duralumin is preferably prepared so that the intermediate layer has substantially the same mechanical properties such as hardness or Young's modulus.

A hardness of the intermediate layer can be controlled to 90 to 110 % the hardness of the substrate. Similarly, Young's modulus can be controlled.
When an amount of carbon exceeds that of the atomic ratio of A14C3, a strength of the intermediate layer increases as the carbon content increases.

On the other hand, a hardness of A14C3 is close to that of aluminum; even when a content of aluminum increases towards the substrate, a little of strength changes. Therefore, if the thickness of the layer containing a relatively large amount of aluminum is large, adhesion strength lowers. A composition of the intermediate layer should be A14C3 near the substrate.

In order to make a friction coefficient of the surface of the coating lower, it is necessary to prepare a composition of the surface of the coating that comes into contact with a counter member, the composition giving a low friction to the surface of the intermediate layer. In order to make the friction of the surface lower, a content of aluminum should be 0.5 to 4.5 at%.

According to application of the sliding members, an amount of aluminum is controlled so as to make the friction coefficient of the surface smaller, when a counter member is metallic material. In case where the counter member is an organic material, an amount of aluminum is controlled to obtain a desired friction coefficient.

In case where a combination of such members that affinity between the members appears after fine abrasion in the surfaces to become the friction coefficient stabile, an amount of aluminum is reduced to obtain a coating with an excellent abrasion resistance.

As has been described, it is possible to obtain coatings with high adhesion property in various light metal alloys such as Al alloy, Mg alloy or Ti alloy so that the sliding members can be light-weighted.

These light weight metal alloys are subjected to a final heat treatment at 120 to 200°C. The intermediate layer of the light metal alloys is formed by a physical vapor deposition method such as a sputtering method, an arc-ion plating method, etc to produce a low temperature coating.

As a sputtering source, at least tow targets C and Al or Al alloy are used to control a composition according to positions of the intermediate layer. Target sources of a third and fourth additive element can be added if desired.

Especially, UBMS (Unbalanced Magnetron Sputter) method enables a temperature of the substrate 200 °C or lower at high speed of coating formation to produce a high density coating.

Because just addition of aluminum to the substrate increases adhesion of the carbon coating to the substrate, a chromium layer, which has been utilized to increase adhesion between the carbon layer and the substrate, which leads to reduction of the number of the targets for sputtering. Since the number of switching of the targets decreases, a process can be simplified and productivity increases and the process is economical.

According to the present invention, an article with excellent adhesion and withstand load particularly useful for sliding members is provided.

In the following, embodiments of the present invention will be explained by reference to drawings.

### Embodiment 1

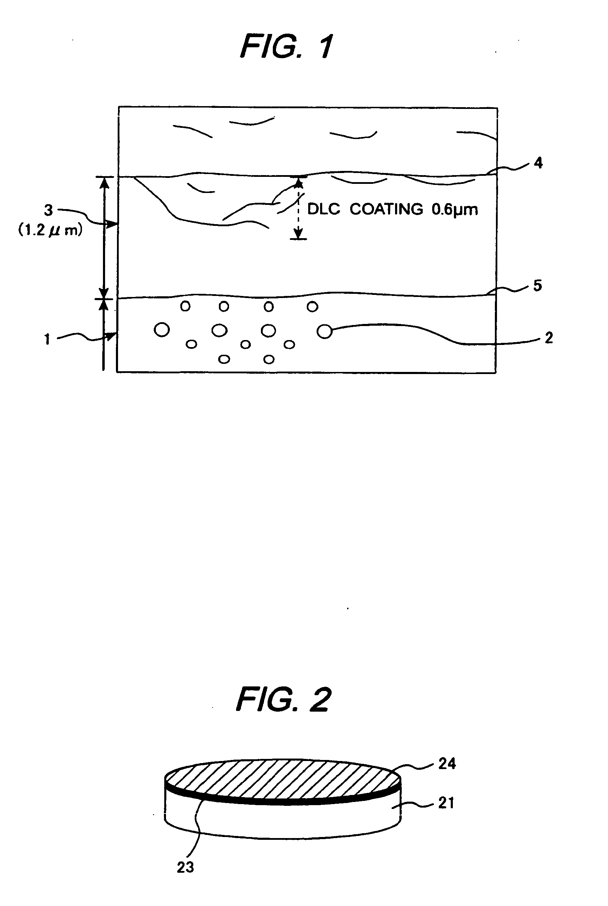

Fig. 1 is a photograph of secondary electron image of a sectional view of a sliding member according to the embodiment, the image being taken with a scanning electron microscope (SEM).

The substrate 1 is made of Al - 11wt% Si, wherein crystals 2 having a diameter micrometer of 0,01 µm of Si are dispersed in the substrate. An interface 5 between the substrate 1 and an intermediate layer 3 including the DLC can be observed.

A thickness of the intermediate layer 3 is 1.2 micrometers. The interface between the intermediate layer 3 and the substrate 1 is made of 100% Al; a concentration of aluminum decreases continuously towards the surface 4 of the intermediate layer.

An inner layer structure of the intermediate layer could not be observed. A portion formed at the surface side 4 of the intermediate layer, which is considered as the intermediate layer 3 is a DLC layer of 0.6 micrometer thick to which Al is added.

Accordingly, there are the intermediate layer of 0.6 micrometer thick and the DCL layer of 0.6 micrometer thick. However, since there is a case where the interface between the intermediate layer of 0.6 micrometer and the DCL layer of 0.6 micrometer is not clear, the total of the 0.6 micrometer layer and the 0.6 micrometer DLC layer are called an intermediate layer 3 in this embodiment. In the following, described is a method for forming the intermediate layer and DLC layer together with compositions thereof.

As shown in Fig. 2, the intermediate layer 3 was formed by the unbalanced magnetron sputtering (UBMS) method where a intermediate layer 23 was formed on a surface 24 of the disc substrate 21. In the UBMS method, a balance among magnetic poles arranged at a rear side of a target is intentionally displaced between the center portion and the peripheral portion of the target, thereby to establish a non-equilibrium so that part of magnetic force lines from the peripheral portion of the target is extended until the substrate and plasma concentrated in the vicinity of the target is diffused until the vicinity of the substrate. As a result, in the process for forming the intermediate layer, an amount of ions irradiated to the substrate is increased thereby to form a dense layer.

In this embodiment, the targets for carbon and aluminum were operated respectively. The above apparatus was provided with the carbon target and the aluminum target; substrates made of three kinds of aluminum base alloys having compositions shown in Table 1, the substrates being mirror-polished, were put in such a way that surfaces the substrates to be treated are directed to the outer periphery of a cylindrical specimen holder in a vacuum chamber, and the chamber was evacuated. The specimen holder was turned around the center axis of the holder.

**Table 1**

| Substrate | Main additive elements (wt%) | | | |
|---|---|---|---|---|
| | Cu | Mn | Mg | Si |
| Al base alloy 1 | 3.8- 5,0 | 0.3-1.0 | 0.2-1.8 | 0.5 or less |
| Al base alloy 2 | 0.15-0.4 | 0.15 or less | 0.8-1.2 | 0.4.-0.8 |
| Al base alloy 3 | 2.0-5.0 | 0.5 or less | 0.6 or less | 4.0-12.0 |

Ar was introduced into the chamber, and at the same time, a heating filament disposed in the chamber was supplied electric current and a bias voltage was applied intermittently to the substrate thereby to remove stains and thin oxide film were removed.

Thereafter, while methane gas was being introduced into the chamber, film forming was carried out, operating the Al target and the C target. Sputtering speeds of C and Al were controlled by an input power to the targets wherein concentrations of the intermediate from 100 % of Al - 0% C to 100 % of C - 0% Al were changed.

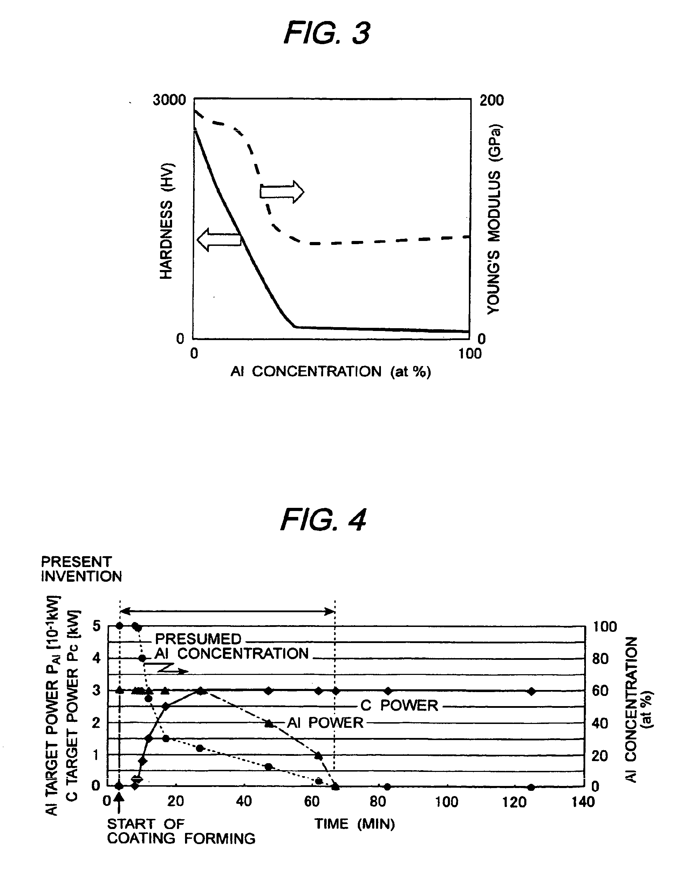

A bias voltage applied to the substrate during film forming was made constant to -100V, and the temperature was kept to about 200 ?. At first, a carbon film with a constant Al concentration from the substrate side to the surface thereof and a thickness of 0.6 micrometer was prepared, and its hardness and Young's modulus were measured. Further, homogeneous films having different concentrations of Al were formed, a relationship between concentration of Al and hardness and Young's modulus of the films were shown in Fig. 3. The hardness and Young's modulus were measured by the nano-indentation method (ISO14577), and the hardness was converted into equivalent numbers to Vickers hardness.

The nano-indentation method was carried out by inserting Berkovich indenter with an angle of 115 degrees between opposite edges into the surface of the film for 10 seconds until the maximum load of 3mN at which the maximum load was maintained for 1 second, followed by releasing the load in 10 seconds.

The hardness decreases as the concentration of Al increases; the hardness became almost constant over 35 at% or more of Al. Young's modulus decreases as the concentration of Al increases.

In case of a film of a concentration of Al being about 35 at%, Al4C3 formation was confirmed by measurement with an XPS (X-ray Photoelectron Spectroscopy). Under the above circumstances, a part of the intermediate layer 3 was formed until a thickness of 0.6 micrometer on a substrate of Al alloy, which was subjected to T6 treatment, the concentration of the film being continuously changed from Al 100 % - 0% C to 0 % -100 % C. Thereafter, DLC film of 0.6 micrometer thick was formed on the Al-C film thereby to produce a sliding member having the surface whose cross sectional structure is shown in Fig. 1.

The concentrations of Al and C were so controlled as the hardness of the films in the direction of film growth lineally increases. As shown in Fig. 4, the change of the concentration of Al became a graph being convex downwards, compared to the film whose concentration of Al decreases linearly from 100% to 0%; it is preferable to form at least three or more layers of different Al concentrations (a stepwise increase in the concentration) or a continuously changed Al concentration is preferable.

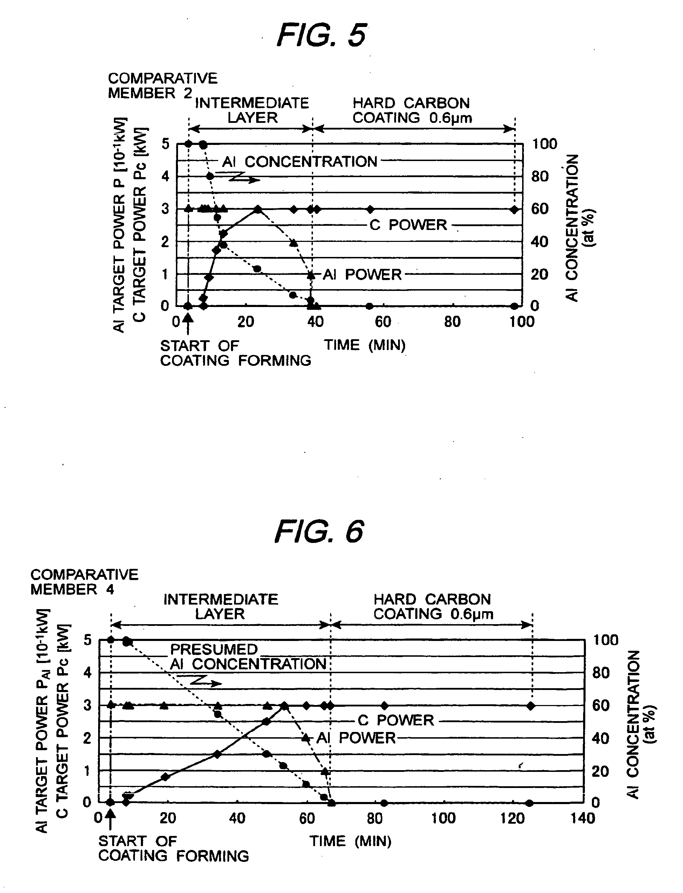

As a comparative member, an intermediate layer of Cr having 0.6 micrometer thick was formed on aluminum base alloy and a DLC layer having 0.6 micrometer thick was formed on the intermediate layer. Further, another comparative member 2 having an intermediate layer where the Al concentration changes continuously is shown in Fig. 5, wherein a concentration of Al changes in a graph being convex downwards.

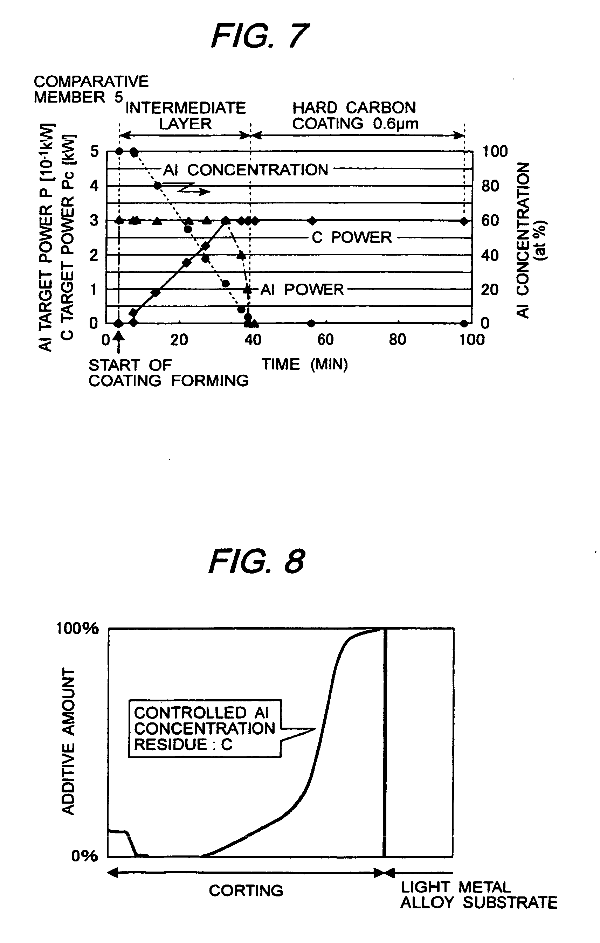

A comparative member 3, which has no intermediate layer but has only a DLC layer, was prepared. A comparative member 4 whose intermediate layer having an Al concentration changing linearly is 0.6 micrometer was prepared. A comparative member 5 is shown in Fig. 7 wherein the concentration is changed in proportion to the thickness. Withstand load properties in traces by a Rockwell C scale were compared.

A round trace was formed by the Rockwell C scale in each of the films, and cracks around the traces were observed. The results are shown in Table 2.

**Table 2**

| Material | Thickness of Cr intermediate layer (µm) | Thickness f Al added intermediate layer µm) | Thickness of High-hardness Carbon layer (µm) | Result of Rockwell C scale | Result of scratch test (%) |
|---|---|---|---|---|---|
| Comparative member 1 | Cr (0.6) | 0.6 | 0.6 | Radial cracks | 100 |
| Present invention | No | 0.6 | 0.6 | No breakage | 171 |
| Comparative member 2 | No | 0.3 | 0.6 | Fine cracks around the trace | 118 |
| Comparative member 3 | No | No | 0.6 | Fine peeling off | 52 |
| Comparative member 4 | No | 0.6 | 0.6 | Radial cracks | 105 |
| Comparative member 5 | No | 0.3 | 0.6 | Fine cracks around the trace | 86 |

In case of the comparative member 1, many radial cracks were generated around the trace. In case of the comparative member 2, circular cracks that surround the trace were formed. In case of the comparative member 3, peeling off of the film was observed so that the substrate around the trace was exposed. In case of the comparative member 4, many radial cracks were formed around the trace. In case of the comparative member 5, circular cracks that surround the trace were formed.

In case of the carbon coating of the present invention, cracks or peeling off were not recognized. A scratch test for evaluating durability of the carbon coating at the time of sliding was conducted.

The scratch test was conducted in the following manner. A diamond indenter worked into a ball having a radius of 200 micrometers was brought into contact with the carbon coating in a perpendicular direction to the surface thereof. A load was gradually increased and the diamond ball was moved in a direction parallel to the surface of the carbon coating to form a scratch. Observation of the scratch makes it possible evaluate durability and peeling off of the carbon coating. A distance of parallel movement was 10 mm.

A load at which a surface of the substrate in the bottom of the scratch was exposed was defined as a critical load. As the standard specimen, the comparative member 1 was used to evaluate the durability.

Compared to the critical load of the comparative member 1, the comparative member 2 exhibited 118%, the comparative member 3 exhibited 52%, the comparative member 4 exhibited 105%, and the comparative member 5 exhibited 86%. The comparative member 2 exhibited a relatively good result.

In case of the carbon coating of the present invention, the critical load was 171 %; it has been revealed that the carbon coating of the present invention has excellent withstand load property and anti-peeling off property, in view of both the Rockwell C scale and the scratch test.

When a hardness increases linearly from the substrate, it was confirmed that the thickness of the intermediate layer needed at least 0.5 µm.

If the composition of the intermediate layer is changed linearly in proportion to time, the change of the composition of Al tends to become convex upwards; since a brittle layer formal to Al4C3 becomes thick thereby to make the durability and anti-peeling off worse.

Accordingly, the present invention provide a high-hardness carbon coating with excellent anti-abrasion property, withstanding load property and high adhesion. According to the present embodiment, since the occurrence of cracks can be suppressed, the anti-corrosion of the substrate is improved by shut-off from the environment. Optimization of the concentration of Al and concentration change in accordance with strength properties of the carbon coating can improve withstanding load property and adhesion property.

When only argon gas was introduced into the chamber without introduced methane gas, a film obtained exhibited the same results. Further, friction coefficients of the different homogeneously Al added carbon coating layers were measured; when 0.5 to 4.5 at% of Al is added, the high-hardness carbon coating exhibited a friction coefficient of the carbon coating was as small as 0.1 or less. Accordingly, in order to reduce a loss of light-weight sliding members, it is effective to control the Al concentration of the surface portion of the carbon coating.

On the other hand, since a high-hardness carbon coating to which 0.5 to 4.5 at% of Al is added decreases its hardness, an additive amount of Al to satisfy adhesion to the substrate and hardness of the interior, i.e. both anti-abrasion property and low friction property. A C target and Al target were set in the UBMS apparatus; in addition to the above procedure of producing the specimens shown in Fig. 2, Al was deposited on the surface 24 of the specimen.

An intermediate layer was formed on am aluminum base alloy A2024, which was subjected to T6 heat treatment, wherein the formation of the layer continued until it had a thickness of 0.6 micrometer and Al -C concentrations were continuously changed from 100 at% and 0% to 0 at% and 100 at%, respectively.

Thereafter, a first high hardness carbon coating (DLC) having a thickness of 0.4 micrometer was formed; again, another DLC layer having a thickness of 0.2 micrometer and an Al concentration of 2 at % was formed by operating the Al target on the first carbon coating.

A friction coefficient of the resulting article that was measured in an unlubricated condition was 0.05. If the low friction coefficient is desired for a long period of time, it is desirable to control the minimum concentration of Al in the carbon coating to 0.5 to 4.5 at%.

A hardness in the vicinity of the interface between the coating and the substrate in this embodiment was investigated in detail; as a result, it was revealed that the carbon coating was softer than the substrate. It is possible to improve adhesion to the substrate by increasing a strength of the coating at the substrate side.

In forming the coating at the substrate side by sputtering, it is effective to add and alloy elements selected from main components of the substrate alloy or additive elements to the substrate alloy, which increase strength of aluminum.

In this embodiment, Cu, which is a secondary element of A2024 was used. A C target, Al target and Cu target were put in the UBMS apparatus and the above-mentioned sputtering process whose part was modified was conducted wherein immediately after Al sputtering started, the Cu target was operated to thereby add Cu of 4 wt% of the Al concentration.

An atomic ratio of Al to Cu was kept constant at 1.5; concentrations of Al, Cu and C were changed continuously from a total concentration of Al and Cu being 100 % and C being 0% to a total concentration of Al and Cu being 0% and C being 100%. Then, a high-hardness carbon coating (DLC) was grown until 0.6 micrometer thick to obtain an article whose sectional view is shown in Fig. 1.

Concentrations of Al and C were controlled to give hardness which is increases linearly in a growing direction of the coating. When a trace was formed with a Rockwell C scale on the resulting specimen, no cracks were observed. A scratch test result showed an increased adhesion; i.e. a critical load of about 190% that of the comparative member 1 having a Cr intermediate layer.

Using the UBMS apparatus, formation of coating by sputtering of an A2024 alloy target was conducted. There was an adhesion improvement similar to that of a method wherein the Al target and Cu target were cooperatively controlled.

An Al alloy target whose composition is similar to A6061, which has similar strength to the substrate such as A6061, can be used instead of the Al target thereby to improve adhesion property.

Fig. 2 shows a specimen of a substrate 1 having a diameter of 21.5mm, and a thickness of 5.2mm, a high-hardness carbon coating being formed on one face of the specimen. An adhesion, hardness and Young's modulus of the specimen were evaluated. The test was carried out under a bias voltage of 100V. It was possible to provide a carbon coating and article with excellent load withstanding, anti-abrasion and adhesion.

### Embodiment 2

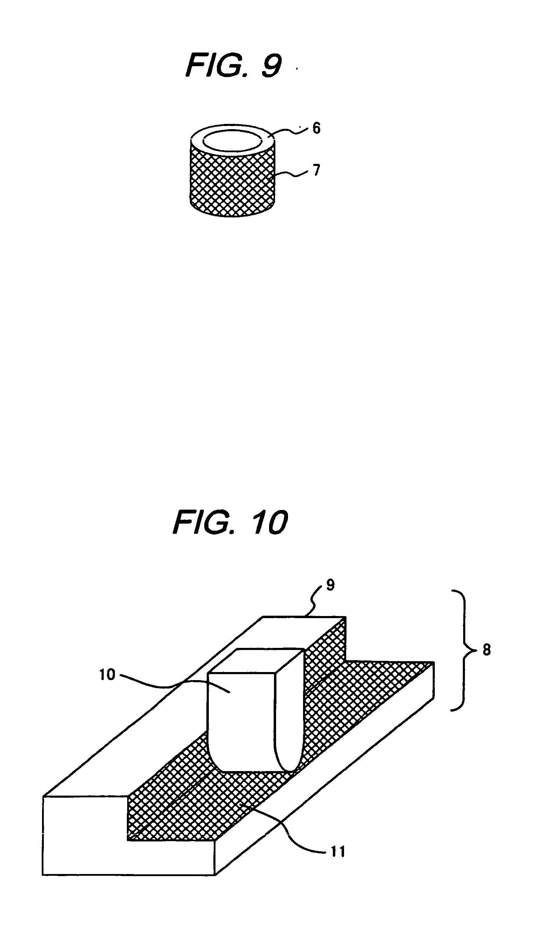

Fig. 9 shows a perspective view of a working piston for transfer liquid to which the carbon coating of the present invention was applied. As the working piston for transfer liquid, which is inserted into a cylinder made of cast steel, for example, and is subjected to repeated friction with the cylinder, pistons made of iron materials have been used. Although light weight pistons are preferable for improving working responsibility, use conditions of light weight pistons made of light metals have been limited because of their poor anti-abrasion. When the piston 6 is made of aluminum alloy and the periphery of the piston is coated with the high-hardness carbon coating, abrasion of the piston was 1/2 of the iron piston under the conditions for practical use and the working responsibility was improved because of lightweight.

A sliding member according to the present invention was used as a guide mechanism 8 for positioning shown in Fig. 10. A guide rail 9 that contacts with the pin 10 for making reciprocal linear movement was made of magnesium alloy and a surface of the pin 10 that contacts with the guide rail was made of the high-hardness carbon coating. As a result, the life of the guide rail could be expanded by about 10 times that of a non-treating member with a carbon coating.

When the pistons, guide rails or counter members are made of the light weight sliding members of the present invention, it is possible to make light weight and anti-abrasion, high reliability of the members. Further, low friction of the members can be realized. The members of the present invention can be applied to parts that are used under similar friction states; for example, in case of cam mechanisms, rolling bearings, gears, etc, light weight and anti-abrasion can be increased and low friction loss can be realized.

The present invention is particularly applied to members used under sliding conditions.

## Claims

1. An article comprising a substrate, an intermediate layer containing aluminum and carbon and a high-hardness carbon coating, wherein a concentration of aluminum in the intermediate layer decreases along the direction from the substrate towards the high-hardness carbon coating, **characterized in that** a decreasing rate of aluminum in an area close to the high-hardness carbon coating being smaller than that in an area close to the substrate.

2. The article according to claim 1, wherein the high-hardness carbon coating contains 0.5 to 4.5 at% of aluminum.

3. The article according to claim 1, wherein a concentration of carbon in the intermediate layer increases along the direction from the substrate towards the high-hardness carbon coating, an increasing rate of carbon being smaller than that in an area close to the substrate.

4. The article according to claim 1, wherein the substrate is an aluminum alloy containing copper in an amount of 1 to 2 at%.

5. The article according to claim 1, wherein the substrate is a member selected from the group consisting of aluminum base alloy, magnesium base alloy, titanium base alloy, aluminum, magnesium and titanium.

6. The article according to claim 1, wherein the high-hardness carbon coating is of diamond-like carbon.

7. The article according to claim 1, wherein the high-hardness carbon coating has 3 thickness of 1 to 2.5 micrometers.

8. The article according to claim 1, wherein the intermediate layer has a thickness of 0,7 to 1,5 micrometers.

9. The article according to claim 1, wherein an aluminum layer or an aluminum base alloy layer free from carbon is formed in an interface of the substrate and the intermediate layer.

10. The article according to claim 1, wherein the intermediate layer is formed by physical vapor deposition.

## Patentansprüche

1. Gegenstand umfassend ein Substrat, eine Zwischenschicht, die Aluminium und Kohlenstoff enthält, und eine Kohlenstoffbeschichtung von großer Härte, wobei eine Konzentration von Aluminium in der Zwischenschicht entlang der Richtung von dem Substrat zu der Kohlenstoffbeschichtung von großer Härte abnimmt, **dadurch gekennzeichnet, dass** eine Abnahmerate von Aluminium in einem Bereich nahe bei der Kohlenstoffbeschichtung von großer Härte kleiner ist als die in einem Bereich nahe bei dem Substrat.

2. Gegenstand nach Anspruch 1, wobei die Kohlenstoffbeschichtung von großer Härte 0,5 bis 4,5 Atom-% Aluminium enthält.

3. Gegenstand nach Anspruch 1, wobei eine Konzentration des Kohlenstoffs in der Zwischenschicht entlang der Richtung von dem Substrat zu der Kohlenstoffbeschichtung von großer Härte zunimmt, und eine Zunahmerate des Kohlenstoffs kleiner ist als in einem Bereich nahe bei dem Substrat.

4. Gegenstand nach Anspruch 1, wobei das Substrat eine Aluminiumlegierung ist, die Kupfer in einer Menge von 1 bis 2 Atom-% enthält.

5. Gegenstand nach Anspruch 1, wobei das Substrat ein Mitglied ist ausgewählt aus der Gruppe bestehend aus einer Legierung auf Aluminiumbasis, einer Legierung auf Magnesiumbasis, einer Legierung auf Titanbasis, Aluminium, Magnesium und Titan.

6. Gegenstand nach Anspruch 1, wobei die Kohlenstoffbeschichtung von großer Härte aus Diamantartigem Kohlenstoff besteht.

7. Gegenstand nach Anspruch 1, wobei die Kohlenstoffbeschichtung von großer Härte eine Dicke von 1 bis 2,5 Mikrometer hat.

8. Gegenstand nach Anspruch 1, worin die Zwischenschicht eine Dicke von 0,7 bis 1,5 Mikrometer hat.

9. Gegenstand nach Anspruch 1, worin eine Aluminiumschicht oder eine Schicht aus einer Legierung auf Aluminiumbasis, die frei von Kohlenstoff ist, an einer Grenzfläche des Substrats und der Zwischenschicht ausgebildet ist.

10. Gegenstand nach Anspruch 1, worin die Zwischenschicht durch physikalische Abscheidung aus der Dampfphase gebildet ist.

## Revendications

1. rticle comprenant un substrat, une couche intermédiaire contenant de l'aluminium et du carbone et un revêtement en carbone à dureté élevée, où une concentration d'aluminium dans la couche intermédiaire décroît dans le sens à partir du substrat vers le revêtement en carbone à dureté élevée, **caractérisé en ce qu'**un taux de décroissance de l'aluminium dans une zone près du revêtement en carbone à dureté élevée étant plus petit que celui dans un zone près du substrat.

2. Article selon la revendication 1, où le revêtement en carbone à dureté élevée contient 0,5 à 4,5 % en poids d'aluminium.

3. Article selon la revendication 1, où une concentration de carbone dans la couche intermédiaire croît dans le sens à partir du substrat vers le revêtement en carbone à dureté élevée, un taux de croissance de carbone étant plus petit que celui dans une zone près du substrat.

4. Article selon la revendication 1, où le substrat est un alliage d'aluminium contenant du cuivre dans une quantité de 1 à 2% en poids.

5. Article selon la revendication 1, où le substrat est un élément sélecté du groupe formé d'alliage à base d'aluminium, alliage à base de magnésium, alliage à base de titane, d'aluminium, magnésium, titane.

6. Article selon la revendication 1, où le revêtement en carbone à dureté élevée est d'un carbone similaire au diamant.

7. Article selon la revendication 1, où le revêtement en carbone à dureté élevée a une épaisseur de 1 à 2,5 micromètres.

8. Article selon la revendication 1, où la couche intermédiaire a une épaisseur de 0,7 à 1,5 micromètres.

9. Article selon la revendication 1, où une couche d'aluminium ou une couche d'alliage à base d'aluminium sans carbone est formée dans une interface du substrat et de la couche intermédiaire.

10. Article selon la revendication 1, où la couche intermédiaire est formée par le dépôt physique en phase vapeur.
